(19) Europäisches Patentamt
European Patent Office
Office européen des brevets

(11) **EP 1 688 974 B1**

(12) **FASCICULE DE BREVET EUROPEEN**

(45) Date de publication et mention
de la délivrance du brevet:
**25.08.2010 Bulletin 2010/34**

(51) Int Cl.:
*H01G 4/258* *(2006.01)*        *H01G 4/02* *(2006.01)*
*H01G 4/28* *(2006.01)*         *G01R 15/16* *(2006.01)*

(21) Numéro de dépôt: **06101328.0**

(22) Date de dépôt: **06.02.2006**

(54) **Condensateur à haute stabilité thermique pour des mesures sur des lignes haute-tension**

Kondensator mit hoher thermischer Stabilität für Messungen in Hochspannungsleitungen

Capacitor with high thermal stability for measurements in high-voltage lines

(84) Etats contractants désignés:
**CH DE GB HU IT LI**

(30) Priorité: **08.02.2005 FR 0550360**

(43) Date de publication de la demande:
**09.08.2006 Bulletin 2006/32**

(73) Titulaire: **AREVA T&D SAS**
**92084 Paris La Défense Cedex (FR)**

(72) Inventeurs:
• **Pohlink, Karsten**
**5035 UNTERENTFELDEN (CH)**
• **Dupraz, Jean-Pierre**
**01360 BRESOLLES (FR)**

(74) Mandataire: **Poulin, Gérard et al**
**BREVALEX**
**3, rue du Docteur Lancereaux**
**75008 Paris (FR)**

(56) Documents cités:
**EP-A- 0 780 692      DE-A1- 2 409 595**
**FR-A- 2 705 492      FR-A- 2 828 003**
**US-A- 4 052 668**

## Description

### DOMAINE TECHNIQUE

L'invention concerne un condensateur pour effectuer des mesures de la tension primaire d'un appareillage à haute tension. L'invention s'applique en particulier à un appareillage électrique haute tension sous enveloppe métallique à isolation gazeuse, tel qu'un câble à isolation gazeuse, ou un élément de poste à haute tension de même technologie

### ÉTAT DE LA TECHNIQUE ANTÉRIEURE

Un tel condensateur est connu des brevets par exemple FR 2828003 ou FR 2705492.

Le condensateur décrit en relation avec le brevet FR 2828003 comporte une enveloppe (ENV) reliée au potentiel de référence « zéro », typiquement la masse électrique de l'appareillage hôte. L'enveloppe (ENV) a une surface interne annulaire sur laquelle un circuit imprimé (CI) est maintenu plaqué mécaniquement et de manière élastique, c'est à dire de manière à autoriser la dilatation du circuit imprimé (CI) tout en le maintenant plaqué sur la face interne de l'enveloppe (ENV).

L'élément soumis à la haute tension à mesurer est relié électriquement à une électrode haute tension (HT) du condensateur. L'électrode haute tension (HT) du condensateur est généralement constituée d'une barre métallique cylindrique. Elle est entourée par une électrode basse tension (BT), laquelle est réalisée au moyen d'une piste électriquement conductrice du circuit imprimé (CI) annulaire. Ce circuit imprimé (CI) assure à la fois le positionnement mécanique de l'électrode basse tension (BT) et son isolement électrique par rapport à l'enveloppe (ENV). L'électrode haute tension (HT), le circuit imprimé (CI), et la surface interne de l'enveloppe (ENV) sont assemblés de façon coaxiale.

Cette structure de condensateur fait apparaître deux condensateurs, respectivement un condensateur haute tension Cht et un condensateur basse tension Cbt. Les armatures du condensateur Cht, sont respectivement les électrodes haute tension (HT) et basse tension (BT), et son diélectrique est le gaz dont est remplie l'enveloppe. Les armatures du condensateur Cbt sont respectivement l'électrode basse tension (BT) et l'enveloppe (ENV), et son diélectrique est le substrat du circuit imprimé, typiquement un matériau composite à base de résine époxy et de fibres de verre ou équivalent.

La stabilité et la précision de la mesure sont dépendantes de la stabilité et de la précision de la capacité Cht, dont la valeur est donnée par la relation:

$$C_{ht} = 2 \cdot \pi \cdot \varepsilon_0 \cdot \varepsilon_r \cdot \frac{S}{D \cdot \ln\left(\dfrac{D}{d}\right)}$$

Formule dans laquelle $\varepsilon_0$ est la permittivité du vide, $\varepsilon_r$ la permittivité relative du gaz diélectrique, D le diamètre de l'électrode basse tension, d le diamètre de l'électrode haute tension et S la surface de l'électrode basse tension (BT) influencée par l'électrode haute tension (HT). Si l'électrode basse tension (BT) est réalisée au moyen de plusieurs électrodes élémentaires mises en parallèle, S représente la surface totale de ces électrodes fractionnaires.

Pour obtenir une mesure de tension de très haute précision, il est donc nécessaire de réaliser une capacité Cht très précise et très stable.

Ce type de condensateur est généralement associé à un appareillage électrique haute tension, lequel est soumis aux, variations de température dues aux conditions climatiques et aux conditions d'exploitation. Ces variations de température s'échelonnent typiquement entre -25°C et + 55 °C pour les applications usuelles, et bien au-delà pour des applications spéciales.

Ces variations de température provoquent des dilatations et contractions des matériaux constitutifs du condensateur qui, en l'absence de précautions spéciales, modifient la capacité du condensateur Cht. Les agencements décrits dans les brevets FR 2828003 et FR 2705492 sont destinées à résoudre ces problèmes de dilatation et de contraction des matériaux.

Le brevet américain US 4 052 668 montre un condensateur de mesure de haute tension avec un conducteur porté à la haute tension placé à l'intérieur d'une électrode cylindrique et isolé électriquement de cette dernière.

### EXPOSÉ DE L'INVENTION

Outre les problèmes de dilatation et de contraction des matériaux, la capacité Cht est dépendante de la permittivité relative $\varepsilon_r$ du gaz utilisé comme diélectrique. Or, cette permittivité est liée à la densité du gaz emplissent l'enveloppe (ENV), densité pouvant varier entre une valeur nominale de remplissage et une valeur minimale autorisée, en raison des fuites possibles de gaz. Cette dépendance est formalisée par la relation suivante, déduite de la loi de Clausius-Mosotti :

$$\varepsilon_r = \frac{1 + 2 \cdot k \cdot \rho}{1 - k \cdot \rho}$$

k est une constante caractéristique du gaz, liée à sa polarisabilité électronique et à sa masse atomique, et p représente la masse volumique du gaz. Dans la pratique, k.p «1. Il s'ensuit que tout en gardant une bonne précision, la formule devient:

$$\varepsilon \approx 1 + 3 \cdot k \cdot \rho$$

Une technique connue de l'état de l'art consiste à mesurer en permanence la masse volumique p du gaz afin de corriger automatiquement par calcul les variations de la permittivité relative déduite de la connaissance de p. Cette masse volumique peut être mesurée soit directement, au moyen d'un densimètre vrai, soit indirectement par une méthode qui consiste à mesurer la pression P et la température T du gaz, et de calculer la masse volumique p au moyen de l'équation d'état du gaz, méthode applicable aussi bien pour un gaz pur que pour un mélange.

Mais dans la pratique, la densité des gaz utilisés dans l'appareillage haute tension est inhomogène, en raison des gradients de température engendrés par les effets conjugués de l'environnement (soleil, pluie,...) et de l'échauffement engendré par les courants primaires au sein de l'appareillage. Par contre, la pression P est homogène et sa mesure ne présente pas de difficultés.

Le but de la présente invention est de continuer à résoudre les problèmes liés aux dilatation et contraction des matériaux constitutifs du condensateur, d'améliorer la précision de mesure de la masse volumique p par une meilleure mesure de la température moyenne T du gaz entre les électrodes haute et basse tension du condensateur Cht.

Ces problèmes sont résolus par l'objet de la revendication 1.

A cet effet, l'invention a pour objet un condensateur à haute stabilité thermique pour effectuer des mesures sur une ligne haute tension tel que décrit dans la demande de brevet FR 2 828 003 précitée, comportant une électrode haute tension (HT), un circuit imprimé (CI) annulaire entourant de façon coaxiale ladite électrode haute tension (HT) et comportant une piste électriquement conductrice formant une électrode basse tension (BT), mais caractérisé en ce que le circuit imprimé (CI) comporte en outre une résistance thermosensible.

Une résistance thermosensible est un dipôle dont la résistance varie, selon une loi connue, en fonction de la température à laquelle il est soumis.

Le positionnement de la résistance thermosensible sur le circuit imprimé de l'électrode basse tension permet d'effectuer une mesure de la température du gaz entre les électrodes du condensateur au plus proche du condensateur, et en particulier de son diélectrique. Comme dans l'art antérieur précité, le circuit imprimé est de préférence fixée de façon élastique sur la face intérieure de l'enveloppe ENV.

Selon un mode de réalisation préféré du condensateur selon l'invention, un écran métallique (EM) est interposé entre la résistance thermosensible et l'électrode haute tension (HT) de manière à protéger la résistance thermosensible de l'influence de la haute tension.

Selon un autre mode de réalisation préféré du condensateur selon l'invention, la résistance thermosensible est constituée par au moins une piste électriquement conductrice du circuit imprimé.

Cette configuration de la résistance thermosensible permet une mesure très fiable de la température car elle donne une vision moyenne de la température sur une grande surface à l'intérieur du condensateur.

Selon un autre mode de réalisation préféré du condensateur selon l'invention, la piste électriquement conductrice est une piste en cuivre, car le cuivre est le matériau de base de la technologie des circuits imprimés et possède des propriétés thermiques idéales pour la réalisation de résistances thermosensibles en particulier aux gammes de température les plus usuelles envisagées pour les appareillage haute tension.

Le condensateur selon l'invention peut présenter en outre les particularités suivantes :

-    La piste de la résistance thermosensible et la piste de l'électrode basse tension sont des pistes annulaires qui entourent l'électrode haute tension;
-    La piste de la résistance thermosensible à une forme de type grecque, droite ou oblique ;
-    La piste de la résistance thermosensible présente de longs segments droits parallèles, électriquement en série ou en parallèle;
-    Le circuit imprimé est un circuit imprimé double face et la résistance thermosensible est formée via des pistes situées sur une seule face du circuit imprimé.
-    Le circuit imprimé est un circuit imprimé double face et la résistance thermosensible est formée via des pistes situées sur chacune des faces du circuit imprimé.
-    Le circuit imprimé est de type multicouches, et la résistance thermosensible est réalisée sur l'une quelconque de ses couches, enfouie ou en surface.
-    La piste de la résistance thermosensible et la piste de l'électrode basse tension sont séparées par une piste de garde reliée au potentiel de référence « zéro ».

La piste de la résistance thermosensible est encadrée de part et d'autre par une piste de garde reliée au potentiel de référence « zéro ».

Dans un mode de réalisation, l'électrode basse tension BT est couplée à un circuit qui asservit électroniquement sa tension à une tension de référence.

## BRÈVE DESCRIPTION DES DESSINS

L'invention sera mieux comprise à la lecture de la description qui suit et à l'examen des figures qui l'accompagnent. Cette description n'est donnée qu'à titre d'exemple indicatif et nullement limitatif de l'invention. Les signes de référence employés dans la description qui va suivre sont les mêmes que ceux employés plus haut pour décrire l'art antérieur, lorsque les éléments ont même fonction que dans l'art antérieur.

La figure 1 est une vue en coupe d'un condensateur selon l'invention dans un mode de réalisation particulier.

La figure 2 est une vue du même dispositif que celui représenté par la figure 1 mais comportant en outre un ou plusieurs écran(s) métallique(s) de protection de la résistance thermosensible.

La figure 3 est un schéma d'un circuit électrique destiné à maintenir constant le potentiel d'une jonction entre les condensateurs haute tension et basse tension.

La figure 4 est une vue en coupe d'une piste d'une résistance thermosensible du condensateur selon l'invention.

Les figures 5 à 9 représentent différents dessins possibles pour une piste d'une résistance thermosensible du condensateur selon l'invention.

**EXPOSÉ DÉTAILLÉ DE MODES DE RÉALISATION PARTICULIERS**

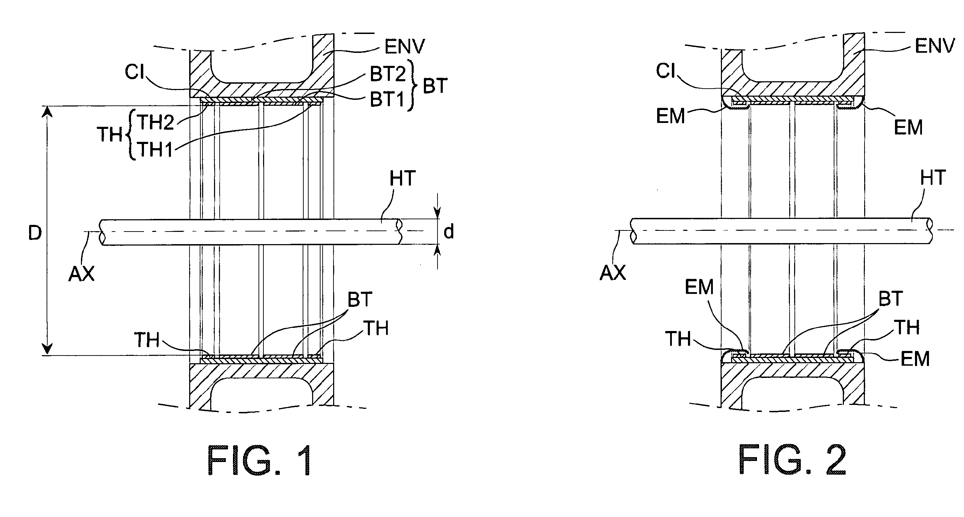

Le condensateur à haute stabilité thermique selon l'invention est comme représenté figure 1, un condensateur annulaire. Il s'agit d'un condensateur où deux systèmes symétriques sont réalisés sur le même circuit imprimé, en vue de créer une redondance.

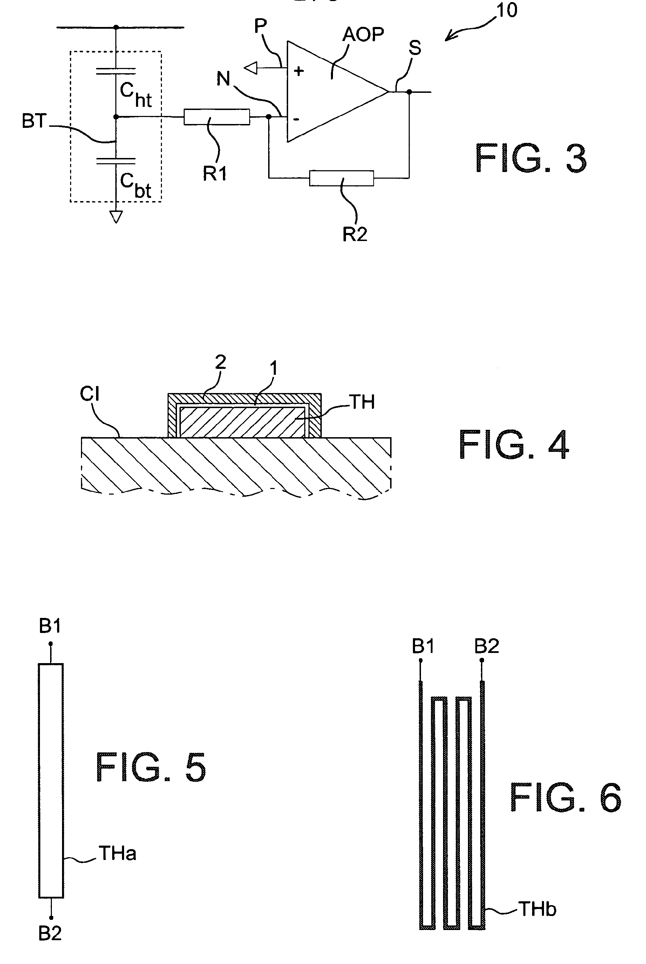

Il comprend une électrode haute tension HT qui s'étend selon un axe principal AX. La figure 1 est une vue du condensateur selon un plan de coupe comprenant ledit axe AX. L'électrode HT, qui est ici une barre métallique cylindrique de diamètre d, est entourée de façon coaxiale par une électrode basse tension BT et par une résistance thermosensible TH, toutes deux sous la forme de pistes annulaires électriquement conductrices d'un circuit imprimé CI annulaire de diamètre D. Le circuit imprimé CI est maintenu dans une enveloppe ENV métallique destinée à être accouplée à un appareillage sous enveloppe métallique rempli de gaz diélectrique tel que le SF6 par exemple. Dans cet exemple le circuit imprimé CI comporte deux sous systèmes identiques et symétriquement disposés de part et d'autre d'un plan de symétrie perpendiculaire à l'axe AX. Chacun des sous systèmes est formé d'une large piste conductrice BT1, BT2 respectivement constituant ensemble l'électrode basse tension BT, et d'une piste TH1, TH2 respectivement, constituant ensemble la résistance thermosensible TH. Chacune des pistes TH1, TH2 peut prendre notamment l'une des formes, représentées sur les figures 5 à 9. Ces figures seront commentées plus loin. Cet ensemble de quatre pistes distinctes BT1, BT2, TH1, TH2, électriquement conductrices et isolées entre elles, est disposé sur la face interne du circuit imprimé CI.

Ces pistes BT1, BT2, TH1, TH2 forment des bandes circulaires qui entourent la barre haute tension HT et sont représentées sur la figure 1 et sur la figure 2 par les zones les plus sombres et les plus proches de l'axe de symétrie AX. Ces bandes sont espacées les unes des autres le long de l'axe AX. Les pistes TH1, TH2 de la résistance thermosensible TH et les pistes BT1, BT2 de l'électrode basse tension BT ne sont pas nécessairement respectivement interconnectées au niveau du circuit imprimé CI. Plus particulièrement, les deux pistes de la résistance thermosensible TH peuvent jouer le rôle de résistance thermosensible TH indépendamment l'une de l'autre et le nombre de pistes sur le circuit imprimé peut varier. Un appareil de mesure de la résistance, non représenté et en lui-même connu, est relié aux pistes de la résistance thermosensible TH en des points B1 et B2 représentés figures 5 à 9 et mesure la résistance de ces pistes. Aussi, les deux pistes BT1, BT2 de l'électrode basse tension BT, qui ne sont pas reliées à l'enveloppe ENV, peuvent jouer le rôle d'électrode basse tension BT indépendamment l'une de l'autre. Comme dans d'autres condensateurs connus l'électrode basse tension BT est couplée à l'enveloppe ENV elle même connectée à la masse au travers de la capacité Cbt. De cette manière les courants hautes fréquences sont écoulés à la masse.

Il est à noter que le circuit imprimé CI peut également comporter une large piste conductrice sur sa face externe, cette piste conductrice étant reliée à la masse à travers le châssis. Cette disposition assure une meilleure maîtrise de la valeur de la capacité auxiliaire Cbt.

Dans le condensateur selon l'invention, la température est mesurée au moyen d'un capteur de température à constantes réparties partageant le même circuit imprimé CI que l'électrode basse tension BT. Ce capteur constitué par la résistance thermosensible TH donne une mesure globale de la température sur l'ensemble de sa surface. De même, l'électrode basse tension BT donne une mesure globale de la capacité Cht sur l'ensemble de sa surface. La résistance thermosensible TH est formée ici par une ou plusieurs pistes électriquement conductrices dont la résistivité varie avec la température. On voit sur la figure 1 que les pistes TH1, TH2 de la résistance thermosensible TH entourent les pistes BT1, BT2 de l'électrode basse tension BT de manière à mesurer la température au plus proche et sur l'ensemble du condensateur. De préférence, les pistes TH1, TH2 électriquement conductrices de la résistance thermosensible TH sont faites en cuivre. Ce matériau est courant dans la technologie des circuits imprimés. Il possède des propriétés thermiques idéales pour la réalisation de résistances thermosensibles. En effet, la résistivité du cuivre, dans la plage de température usuelle dans le domaine concerné, varie fortement avec la température, ainsi qu'en témoigne la valeur élevée, proche de 4000 ppm / °C (partie par million et par degré) de son coefficient de température spécifique. La technologie des circuits imprimés permet de réaliser facilement des pistes dont la résistance électrique totale est de plusieurs dizaines d'Ohms. Il suffit pour cela de choisir une classe de gravure autorisant les épaisseurs de cuivre et les largeurs de pistes voulues, comme par exemple de 10 $\mu$m à 100 $\mu$m pour les épaisseurs et de 50 $\mu$m à 500 $\mu$m pour les largeurs de pistes, et de créer un motif de longueur adaptée à la valeur de résistance voulue. Une valeur typique de 50 Ohms est parfaitement adaptée à ce besoin, bien que d'autres valeurs soient possibles. Cette valeur est suffisamment élevée pour que la mesure soit facile, et suffisamment faible pour assurer une bonne immunité aux perturbations électromagnétiques.

A partir de la mesure de la résistance R de la résistance thermosensible, on déduit de la relation R = f (T) la température de surface du circuit imprimé, qui est une bonne estimation de la température moyenne T du gaz diélectrique du condensateur. Cette mesure permet alors d'une part de corriger les effets des variations de permittivité engendrées par les fuites de gaz, et permet aussi de corriger les dérives thermiques résiduelles de la capacité Cht dues aux dilatations et autres contraintes thermiques.

Par conséquent, il est très simple de réaliser à bas coût et de manière très compacte un condensateur comportant un capteur pour mesurer la température du gaz. Ce capteur est situé directement dans la zone où se situe la capacité dont la valeur permet de connaître la valeur de la constante diélectrique du gaz.

La figure 2 représente le même mode de réalisation que dans la figure 1 mais ce mode comporte en outre un ou plusieurs écran(s) métallique(s) EM. Comme expliqué plus haut ce ou ces écran(s) métallique(s) EM est (sont) interposé(s) entre la résistance thermosensible TH et l'électrode haute tension HT. Ce ou ces écran (s) protègent la résistance thermosensible TH de l'influence directe de la haute tension.

L'électrode haute tension HT, le circuit imprimé CI, le ou les écrans métalliques EM et la surface interne de l'enveloppe ENV sont comme dans l'exemple précédent, assemblés de façon coaxiale.

Dans le mode de réalisation préféré de l'invention la tension de l'électrode basse tension BT est asservie électroniquement à une tension de référence, par exemple la tension de masse, au moyen d'un circuit 10 représenté figure 3.

L'électrode basse tension BT est reliée à une première entrée N d'un amplificateur différentiel AOP, au travers d'une première résistance R1, par exemple de l'ordre d'une centaine d'ohms. Une seconde entrée P de l'amplificateur différentiel AOP est connectée à la masse qui constitue ainsi la tension de référence. La sortie S de l' amplificateur différentiel AOP est rebouclée sur l'entrée N au moyen d'une seconde résistance R2.

Le condensateur Cbt apparaît comme un condensateur auxiliaire n'ayant aucun rôle dans la mesure de la tension aux fréquences industrielles, mais assurant l'évacuation à la masse des perturbations à très hautes fréquences générées par les manoeuvres des éléments de coupure, disjoncteurs ou sectionneurs, du réseau sur lequel l'appareil est installé.

Le courant qui traverse alors la capacité Cht, et qui émerge de l'électrode basse tension BT, est ainsi une image fidèle de la dérivée par rapport au temps de la tension de l'électrode haute tension HT. Un traitement de signal, non décrit ici, permet, par une intégration numérique par exemple, de restituer une image précise de la tension à partir de sa dérivée par rapport au temps ainsi mesurée.

De ce fait, la mesure de la tension appliquée au condensateur faisant l'objet de l'invention se ramène à la mesure du courant traversant la capacité haute tension Cht.

La figure 4 est une vue en coupe d'une piste d'une résistance thermosensible du condensateur selon l'invention. Comme montré sur la figure 4, la piste de cuivre de la résistance thermosensible TH est de préférence recouverte de couches protectrices. Sur la piste de cuivre, peuvent être déposées comme représenté figure 4, successivement une couche 1 de nickel et d'or pour éviter l'oxydation et une couche 2 de vernis épargne.

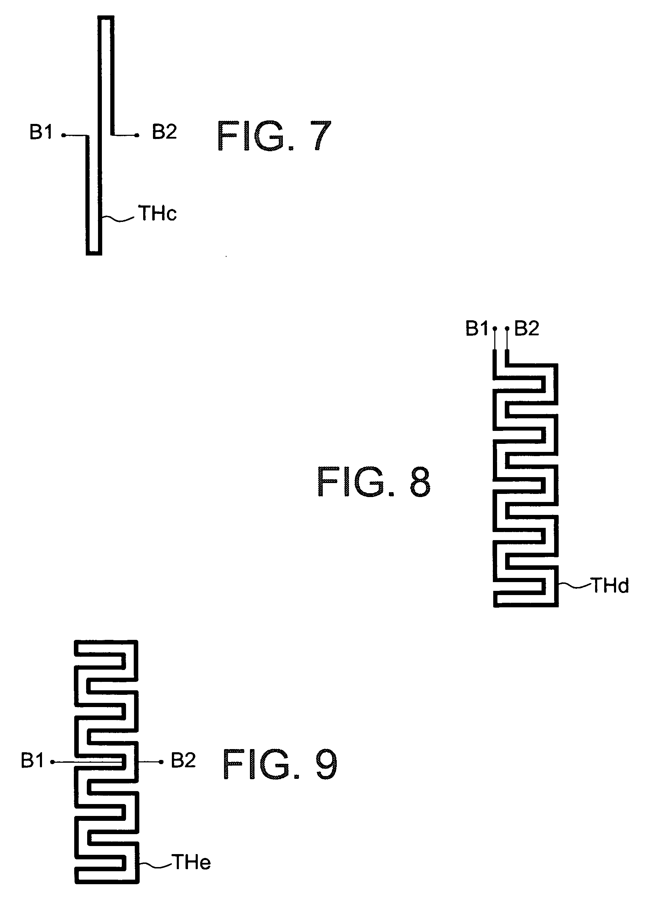

Comme on peut le voir figure 5 à 9, une piste de cuivre de la résistance thermosensible TH peut présenter des formes variées. Ces figures ne représentent qu'une illustration de motifs de la piste qui est répété maintes fois. Par exemple, sur la figure 5, la piste de la résistance thermosensible THa est une piste droite avec des bornes de connexion B1 et B2 à chaque extrémité. Sur la figure 6 et la figure 7 la piste de la résistance thermosensible, respectivement THb et THc, est formée de longs segments droits parallèles avec les deux bornes de connexion B1 et B2 situées d'un même côté sur la figure 6, et au centre sur la figure 7. Les pistes des résistances thermosensibles THd et THe présentées respectivement sur la figure 8 et la figure 9 sont de type "grecque", c'est à dire avec des chicanes. En variante, les chicanes peuvent être réalisées de façon oblique. Sur la figure 8 les bornes B1 et B2 de la piste de la résistance thermosensible THd sont sur un même côté à chaque extrémité de la piste, tandis que dans le cas illustré par la figure 9, la piste de la résistance thermosensible THe forme un circuit fermé avec des bornes B1 et B2 au centre et présente donc les caractéristiques de deux pistes en parallèles. Les pistes de la résistance thermosensible TH peuvent présenter de nombreuses autres formes avec des bornes de connexion disposées à des endroits appropriées.

Le circuit imprimé CI annulaire peut être formé en plusieurs morceaux qui forment alors ensemble, un unique circuit imprimé.

## Revendications

**1.** Condensateur à haute stabilité thermique pour effectuer des mesures sur une ligne haute tension comportant une électrode haute tension (HT), un circuit imprimé (CI) annulaire entourant de façon coaxiale ladite électrode haute tension (HT) et comportant au moins une piste électriquement conductrice formant une électrode basse tension (BT), **caractérisé en ce que** le circuit imprimé (CI) comporte en outre au moins une résistance thermosensible (TH) destinée à être reliée à un appareil de mesure de la résistance thermosensible.

**2.** Condensateur selon la revendication 1, dans lequel un ou plusieurs écran(s) métallique(s) (EM) est (sont) interposé(s) entre la résistance thermosensible (TH) et l'électrode haute tension (HT).

**3.** Condensateur selon l'une des revendications 1 ou 2, dans lequel la résistance thermosensible (TH) est constituée par au moins une piste électriquement conductrice du circuit imprimé.

**4.** Condensateur selon la revendication 3, dans lequel la piste électriquement conductrice de la résistance thermosensible (TH) est une piste en cuivre.

**5.** Condensateur selon l'une des revendications 3 ou 4, dans lequel la piste de la résistance thermosensible (TH) et la piste de l'électrode basse tension (BT) sont des pistes annulaires qui entourent l'électrode haute tension (HT).

**6.** Condensateur selon l'une des revendications 3 à 5, dans lequel la piste de la résistance thermosensible (THd, THe) a une forme de type grecque.

**7.** Condensateur selon l'une des revendications 3 à 5, dans lequel la piste de la résistance thermosensible (THb) présente de longs segments droits parallèles.

**8.** Condensateur selon l'une des revendications 3 à 7, dans lequel le circuit imprimé (CI) est un circuit imprimé double face et dans lequel au moins une piste de la résistance thermosensible (TH) est formée sur chaque face du circuit imprimé.

**9.** Condensateur selon l'une des revendications 3 à 7, dans lequel le circuit imprimé (CI) est un circuit imprimé multicouche et dans lequel est logé, sur une ou plusieurs couches internes, au moins une piste de la résistance thermosensible (TH).

**10.** Condensateur selon l'une des revendications 3 à 7, dans lequel le circuit imprimé (CI) est un circuit imprimé multicouche et dans lequel est logé, sur une ou plusieurs couches externes, au moins une piste de la résistance thermosensible (TH).

**11.** Condensateur selon l'une des revendications 3 à 7, dans lequel la piste de la résistance thermosensible et la piste de l'électrode basse tension sont séparées par une piste de garde reliée au potentiel de référence « zéro ».

**12.** Condensateur selon l'une des revendications 3 à 7, dans lequel la piste de la résistance thermosensible est encadrée de part et d'autre par une piste de garde reliée au potentiel de référence « zéro ».

**13.** Condensateur selon l'une des revendications 1 à 12, dans lequel l'électrode basse tension (BT) est couplée à un circuit (10) qui asservit électroniquement sa tension à une tension de référence.

**Claims**

**1.** A highly temperature-stable capacitor for taking measurements on a high-voltage line, said capacitor having a high-voltage electrode (HT), an annular printed circuit (CI) surrounding said high-voltage electrode (HT) coaxially and having at least one electrically conductive track that forms a low-voltage electrode (BT), said capacitor being **characterized in that** the printed circuit (CI) also has at least one temperature-sensitive resistor (TH) intended to be connected to a measuring instrument of the temperature-sensitive resistor.

**2.** A capacitor according to claim 1, in which one or more metal screens (EM) is/are interposed between the temperature-sensitive resistor (TH) and the high-voltage electrode (HT).

**3.** A capacitor according to claim 1 or claim 2, in which the temperature-sensitive resistor (TH) is constituted by at least one electrically-conductive track of the printed circuit.

**4.** A capacitor according to claim 3, in which the electrically conductive track of the temperature-sensitive resistor (TH) is a copper track.

**5.** A capacitor according to claim 3 or claim 4, in which the temperature-sensitive resistor (TH) and the track of the low-voltage electrode (BT) are annular tracks that surround the high-voltage electrode (HT).

**6.** A capacitor according to any one of claims 3 to 5, in which the track of the temperature-sensitive resistor (THd, The) has a shape of the Greek frieze pattern type.

**7.** A capacitor according to any one of claims 3 to 5, in which the track of the temperature-senSitive resistor (THb) has long, parallel straight-line segments.

**8.** A capacitor according to any one of claims 3 to 7, in which the printed circuit (CI) is a double-sided printed circuit in which at least one track of the temperature-sensitive resistor (TH) is formed on each side of the printed circuit.

9. A capacitor according to any ore of claims 3 to 7, in which the printed circuit (CI) is a multi-layer printed circuit and in which at least one track of the temperature-sensitive resistor (TH) is received on one or more inner layers.

10. A capacitor according to any one of claims 3 to 7, in which the printed circuit (CI) is a mufti-layer printed circuit in which at least one track of the temperature-sensitive resistor (TH) is received on one or more outer layers.

11. A capacitor according to any ane of claims 3 to 7, in which the track of the temperature-sensitive resistor and the track of the low-voltage electrode are separated by a guard track connected to a "zero" reference potential.

12. A capacitor according to any one of claims 3 to 7, in which the track of the temperature-sensitive resistor is flanked on either side by a guard track that is connected to a "zero" reference potential.

13. A capacitor according to any ore of claims 1 to 12, in which the low-voltage electrode BT is coupled to a circuit (10) which electronically servo-controls its voltage to a reference voltage.

**Patentansprüche**

1. Hochtemperaturbeständiger Kondensator zum Durchführen von Messungen an einer Hochspannungsleitung, enthaltend eine Hochspannungselektrode (HT), eine ringförmige Leiterplatte (C1), welche die Hochspannungselektrode (HT) koaxial umgibt, sowie zumindest eine elektrische Leiterbahn, die eine Niederspannungselektrode (BT) bildet, **dadurch gekennzeichnet, dass** die Leiterplatte (CI) ferner zumindest eignen wärmeempfindlichen Widerstand (TH) aufweist, der dazu bestimmt ist, mit einer Einrichtung zum Messen des wärmeempfindlichen Widerstands verbunden zu werden.

2. Kondensator nach Anspruch 1, wobei eine bzw. mehrere Metallblende(n) (EM) zwischen den wärmeempfindlichen Widerstand (TH) und der Hochspannungselektrode (HT) eingesetzt ist/sind.

3. Kondensator nach einem der Ansprüche 1 oder 2, wobei der wärmeempfindliche Widerstand (TH) aus zumindest einer elektrischen Leiterbahn der Leiterplatte besteht.

4. Kondensator nach Anspruch 3, wobei die elektrische Leiterbahn des wärmeempfindlichen Widerstands (TH) eine Kupferbahn ist.

5. Kondensator nach einem der Ansprüche 3 oder 4, wobei die Leiterbahn des wärmeempfindlichen Widerstands (TH) und die Leiterbahn der Niederspannungselektrode (BT) ringförmige Leiterbahnen sind, welche die Hochspannungselektrode (HT) umgeben.

6. Kondensator nach einem der Ansprüche 3 bis 5, wobei die Leiterbahn des wärmeempfindlichen Widerstands (THd, The) eine Mäanderform hat.

7. Kondensator nach einem der Ansprüche 3 bis 5, wobei die Leiterbahn des wärmeempfindlichen Widerstands (THb) längere gerade Segmente aufweist, die parallel verlaufen.

8. Kondensator nach einem der Ansprüche 3 bis 7, wobei die Leiterplatte (CI) eine doppelseitige Leiterplatte ist und wobei zumindest eine Leiterbahn des wärmeempfindlichen Widerstands (TH) an jeder Seite der Leiterplatte ausgebildet ist.

9. Kondensator nach einem der Ansprüche 3 bis 7, wobei die Leiterplatte (CI) eine mehrlagige Leiterplatte ist und wobei an einer bzw. an mehreren inneren Lagen zumindest eine Leiterbahn des wärmeempfindlichen Widerstands (TH) angeordnet ist.

10. Kondensator nach einem der Ansprüche 3 bis 7, wobei die Leiterplatte (CI) eine mehrlagige Leiterplatte ist und wobei an einer bzw. an mehreren äußerten Lagen zumindest eine Leiterbahn des wärmeempfindlichen Widerstands (TH) angeordnet ist.

11. Kondensator nach einem der Ansprüche 3 bis 7, wobei die Leiterbahn des wärmeempfindlichen Widerstands und die Leiterbahn der Niederspannungselektrode durch eine mit dem "Null"-Bezugspotential verbundene Schutzbahn getrennt sind.

12. Kondensator nach einem der Ansprüche 3 bis 7, wobei die Leiterbahn des wärmeempfindlichen Widerstands beiderseits von einer mit dem "Null"-Bezugspotential verbundenen Schutzbahn umgeben wird.

13. Kondensator nach einem der Ansprüche 1 bis 12, wobei die Niederspannungselektrode (BT) an eine Schaltung (10) gekoppelt ist, welche ihre Spannung elektronisch mit einer Bezugsspannung abgleicht.

FIG. 1

FIG. 2

EP 1 688 974 B1

FIG. 3

FIG. 4

FIG. 5

FIG. 6

B1 • • B2   FIG. 7

THc

B1 • • B2

FIG. 8

THd

B1 • • B2   FIG. 9

THe

**EP 1 688 974 B1**

**RÉFÉRENCES CITÉES DANS LA DESCRIPTION**

**Documents brevets cités dans la description**

- FR 2828003
- FR 2705492
- US 4052668 A